(19) Europäisches Patentamt

European Patent Office

Office européen des brevets

(11) **EP 1 653 241 A1**

(12) **DEMANDE DE BREVET EUROPEEN**

(43) Date de publication:
**03.05.2006 Bulletin 2006/18**

(51) Int Cl.:
***G01R 31/36*** (2006.01)

(21) Numéro de dépôt: **05292198.8**

(22) Date de dépôt: **19.10.2005**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **27.10.2004 FR 0411469**

(71) Demandeur: **Peugeot Citroen Automobiles SA
78140 Vélizy Villacoublay (FR)**

(72) Inventeurs:
• **Ragot, Franck
75009 Paris (FR)**

• **Grégoire, Gilles
78220 Viroflay (FR)**
• **Sabatier, Jocelyn
33400 Talence (FR)**
• **Oustaloup, Alain
33400 Talence (FR)**
• **Malti, Rachid
33000 Bordeaux (FR)**

(74) Mandataire: **Habasque, Etienne J. Jean-François et al
Cabinet Lavoix
2, Place d'Estienne d'Orves
75441 Paris Cédex 09 (FR)**

(54) **Système de détermination de l'état de charge de moyens de stockage d'énergie électrique de véhicule**

(57) L'invention concerne un système de détermination de l'état de charge de moyens (10) de stockage d'énergie électrique de véhicule. Ce système comprend des moyens (14) de détection et d'acquisition d'un courant d'un type prédéterminé, échangé entre les moyens (10) de stockage et leur environnement, des moyens (18) d'acquisition d'une réponse en tension des moyens de stockage à ce courant échangé, des moyens (20) d'établissement de réponses en tension à ce courant échangé d'un ensemble de modèles prédéterminés des moyens (10) de stockage correspondant à différents états de charge de ceux-ci, des moyens (28) pour comparer la réponse en tension acquise aux réponses en tension établies, et pour identifier le modèle dont la réponse est la plus proche de la réponse des moyens (10) de stockage et des moyens (30) de détermination de l'état de charge des moyens (10) de stockage comme étant l'état de charge correspondant au modèle identifié.

**Description**

La présente invention concerne un système de détermination de l'état de charge de moyens de stockage d'énergie électrique d'un véhicule.

Les moyens de stockage d'énergie électrique, constitués par exemple d'une batterie, sont un élément central pour le fonctionnement du véhicule, par exemple du type automobile, motocycle, etc...

Ils participent par exemple au démarrage du moteur thermique d'un véhicule automobile, à l'alimentation électrique de divers organes fonctionnels du véhicule comme l'électronique embarquée, l'éclairage, etc...Ils peuvent être également la ou une source d'énergie pour la traction d'un véhicule électrique ou hybride.

Leur rôle central dans le fonctionnement du véhicule nécessite de connaître leur état de charge, par exemple, pour des besoins de sécurité liés aux systèmes de freinage et de direction, de gestion du choix de la motorisation dans un véhicule hybride ou d'avertissement de leur recharge nécessaire adressé à un utilisateur d'un véhicule électrique.

On connaît dans l'état de la technique des systèmes de détermination de l'état de charge de moyens de stockage d'énergie électrique qui mesurent le courant échangé par ceux-ci avec leur environnement et estiment l'état de charge en utilisant une cartographie prédéterminée d'états de charge en fonction du courant échangé mesuré.

Toutefois ces systèmes présentent une faible robustesse vis-à-vis de variations des caractéristiques des moyens de stockage d'énergie électrique, comme par exemple la variation de leur rendement de charge. Afin de tenir compte de ces variations, ces systèmes nécessitent typiquement des recalages fréquents et complexes pour compenser leurs erreurs d'estimation. De plus, les recalages de ces systèmes nécessitent que les moyens de stockage soient au repos pendant une durée minimale importante. Or, ces derniers le sont rarement du fait qu'ils alimentent sensiblement en continu par exemple certains organes fonctionnels comme l'électronique embarquée d'un véhicule automobile, de sorte que ces recalages sont difficilement réalisables en pratique.

Le but de l'invention est de résoudre les problèmes susmentionnés en proposant un système de détermination de l'état de charge de la batterie robuste, rapide et ne nécessitant pas que les moyens de stockage d'énergie électrique soient au repos pour la détermination de leur état de charge.

A cet effet, l'invention a pour objet un système de détermination de l'état de charge de moyens de stockage d'énergie électrique de véhicule, caractérisé en ce qu'il comprend :

- des moyens d'acquisition d'un courant prédéterminé échangé entre les moyens de stockage d'énergie électrique et leur environnement ;
- des moyens d'acquisition d'une réponse en tension des moyens de stockage d'énergie électrique au courant échangé ;
- des moyens de détermination de réponses en tension au courant échangé d'un ensemble prédéterminé de modèles des moyens de stockage d'énergie électrique; et
- des moyens de comparaison adaptés pour comparer la réponse en tension des moyens de stockage d'énergie électrique aux réponses en tension de l'ensemble prédéterminé de modèles et déterminer, en fonction de cette comparaison, l'état de charge des moyens de stockage d'énergie électrique conformément à une cartographie prédéterminée entre des valeurs d'état de charge et l'ensemble prédéterminé de modèles.

Suivant d'autres caractéristiques :

- le système comprend en outre, raccordés aux moyens de stockage d'énergie électrique, des moyens de sollicitation en courant de ceux-ci selon une consigne prédéterminée de courant ;
- la consigne prédéterminée de courant est une séquence binaire pseudo-aléatoire prédéterminée excitatrice dans une bande prédéterminée de fréquences pour laquelle les modèles de l'ensemble de modèles sont représentatifs de la réponse fréquentielle en tension des moyens de stockage d'énergie électrique ;
- les moyens de comparaison comprennent :

  - des moyens de formation des erreurs quadratiques entre la réponse en tension acquise des moyens de stockage d'énergie électrique et les réponses en tension établies de l'ensemble de modèles prédéterminés ; et
  - des moyens d'identification du modèle dont la réponse en tension établie est la plus proche de la réponse en tension acquise des moyens de stockage d'énergie électrique comme étant le modèle associé à l'erreur quadratique minimale.

- les moyens de comparaison comprennent :

  - des moyens de détermination des intercorrelations entre la réponse en tension acquise des moyens de stockage d'énergie électrique et les réponses en tension établies de l'ensemble de modèles prédéterminés; et
  - des moyens d'identification du modèle dont la réponse en tension établie est la plus proche de la réponse en tension acquise des moyens de stockage d'énergie électrique comme étant le modèle associé à l'intercorrelation maximale.

- les moyens de comparaison comprennent :

  - des moyens de détermination des transformée de Fourier des réponses en tension acquise des moyens de stockage d'énergie électrique et des réponses en tension établies de l'ensemble de modèles prédéterminés;

- des moyens de formation des erreurs quadratiques entre la transformée de Fourier de la réponse en tension acquise des moyens de stockage d'énergie électrique et les transformées de Fourier des réponses en tension établies de l'ensemble de modèles prédéterminés ; et

- des moyens d'identification du modèle dont la réponse en tension établie est la plus proche de la réponse en tension acquise des moyens de stockage d'énergie électrique comme étant le modèle associé à l'erreur quadratique de transformées de Fourier minimale.

- l'ensemble de modèles prédéterminés est constitué d'un ensemble de modèles prédéterminés non entiers de la transmittance des moyens de stockage d'énergie électrique, chacun représentatif d'une valeur prédéterminée d'état de charge des moyens de stockage d'énergie électrique.

- l'ensemble de modèles prédéterminés non-entiers de la transmittance des moyens de stockage d'énergie électrique est constitué de modèles selon la relation :

$$H(p) = K \left( \frac{1 + \dfrac{p}{\omega_b}}{1 + \dfrac{p}{\omega_r}} \right)^n$$

où H est un modèle de transmittance en fonction de la variable de Laplace p, n est un ordre non entier prédéterminé, et K, $\omega_b$ et $\omega_r$ sont des paramètres prédéterminés, n, K, $\omega_b$ et $\omega_r$ étant représentatifs ensembles de l'état de charge des moyens de stockage d'énergie électrique.

La présente invention sera mieux comprise à la lecture de la description qui va suivre, donnée uniquement à titre d'exemple et faite en relation à la figure annexée qui est une vue schématique du système selon l'invention associé à des moyens de stockage d'énergie électrique de véhicule.

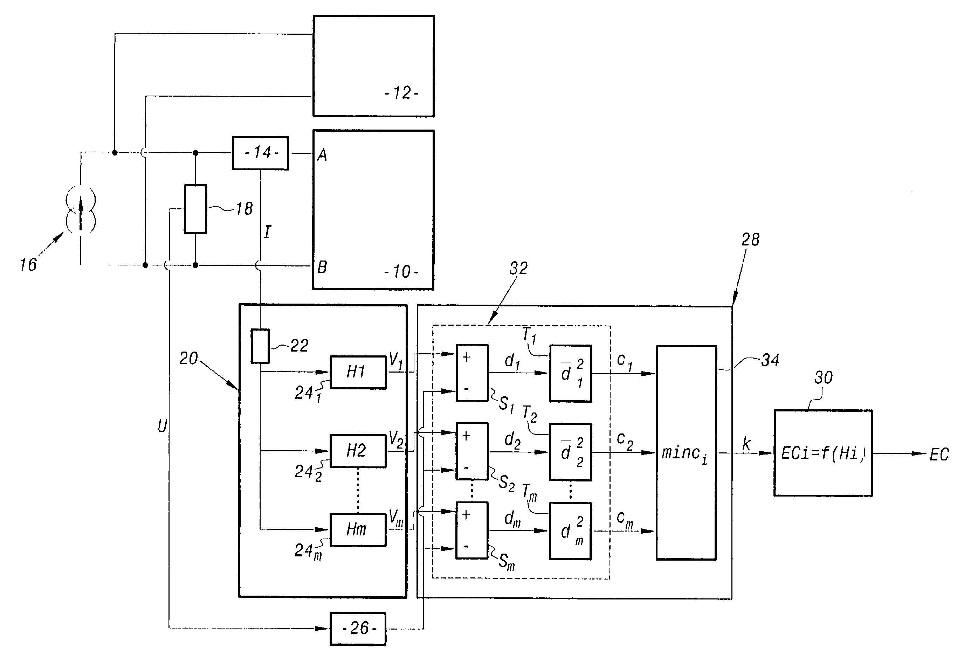

Sur la figure 1, on a illustré de manière schématique un système de détermination de l'état de charge EC de moyens 10 de stockage d'énergie électrique, par exemple constitués d'une batterie, de véhicule, par exemple du type automobile, motocycle ou autres.

Un ensemble 12 prédéterminé d'organes fonctionnels du véhicule est raccordé aux bornes A, B des moyens 10 de stockage. L'ensemble 12 d'organes comprend par exemple des moyens de motorisation du véhicule du type comprenant un alternateur classique, l'éclairage, le système de freinage, le système de direction. Cet ensemble 12 d'organes fonctionnels échange du courant électrique avec les moyens 10 de stockage pour leur alimentation en énergie électrique ou pour la recharge des moyens 10 de stockage par l'alternateur des moyens de motorisation, comme cela est connu en soi dans l'état de la technique.

Le système de détermination de l'état de charge des moyens 10 de stockage comprend des moyens 14 de détection et d'acquisition d'un courant I total échangé, d'un type prédéterminé, entre les moyens 10 de stockage et leur environnement. Plus particulièrement, les moyens 14 sont adaptés pour détecter et acquérir un courant total échangé déterminé afin de réaliser une détermination satisfaisante de l'état de charge des moyens 10 de stockage, comme cela sera expliqué plus en détail par la suite.

L'environnement des moyens 10 de stockage est constitué de l'ensemble 12 d'organes fonctionnels et, dans un premier mode de réalisation du système selon l'invention, de moyens 16 de sollicitation du système de détermination.

Les moyens 16 de sollicitation sont adaptés pour solliciter en courant les moyens 10 de stockage selon une consigne prédéterminée de courant. Cette consigne en courant est sélectionnée de sorte que le courant total échangé par les moyens 10 de stockage, qui est acquis par les moyens 14 de détection et d'acquisition de courant, est du type prédéterminé de courant, comme cela sera expliqué plus en détail par la suite.

Le système de détermination comprend en outre des moyens 18 d'acquisition de la réponse en tension U des moyens 10 de stockage au courant total échangé acquis par les moyens 14 d'acquisition. A cet effet, les moyens 18 d'acquisition de la réponse en tension comprennent par exemple un capteur de tension raccordé aux bornes A, B des moyens 10 de stockage et synchronisé sur les moyens 14 d'acquisition pour l'acquisition en continu de la tension aux bornes des moyens 10 de stockage qui correspond au courant total I acquis par les moyens 14.

Le système selon l'invention comprend par ailleurs des moyens 20 d'établissement de réponses en tension d'un ensemble de m modèles prédéterminés H1, H2, ..., Hm de la transmittance des moyens de stockage, où m est un nombre prédéterminé. Les moyens 20 reçoivent en entrée le courant I acquis par les moyens 14 d'acquisition de courant et sont adaptés pour déterminer la réponse temporelle en tension V1, V2, ..., Vm de chacun de ces modèles au courant acquis.

De manière avantageuse, les m modèles de la transmittance des moyens 10 de stockage appartiennent à la classe de modèles fréquentiels H(p) non entiers selon la relation :

$$H(p) = K \left( \frac{1 + \dfrac{p}{\omega_b}}{1 + \dfrac{p}{\omega_r}} \right)^n$$

où p est la variable de Laplace, n est un ordre non entier prédéterminé, et K, $\omega_b$ et $\omega_r$ sont des paramètres prédéterminés de cette classe de modèles.

L'ordre non entier n et les valeurs des paramètres K, $\omega_b$ et $\omega_r$ des modèles H1, H2, ..., Hm ont été identifiées lors d'une étude antérieure et sont mémorisés dans les moyens 20 d'établissement de leur réponse en tension.

La transmittance des moyens 10 de stockage dépend de leur état de charge et il peut être montré que les paramètres n, K, $\omega_b$ et $\omega_r$ sont représentatifs ensemble de l'état de charge des moyens 10 de stockage. Une cartographie d'états de charge EC est ainsi prédéterminée lors de l'étude antérieure et consiste en une correspondance bijective ECi = f(Hi) entre l'ensemble prédéterminé de modèles H1, H2, ..., Hm et un ensemble prédéterminé de valeurs d'état de charge EC1, EC2, ..., ECm respectivement.

Les modèles sont sélectionnés pour obtenir une cartographie bijective sensiblement complète de la plage des valeurs utiles d'état de charge. Le nombre et la dispersion des modèles H1, H2, ..., Hm sont également choisis pour satisfaire un compromis entre temps de calcul nécessaire à l'établissement de l'ensemble des réponses en tension de ces modèles et une précision satisfaisante sur l'état de charge des moyens 10 de stockage.

Comme il est possible de le constater, les modèles H1, H2, ..., Hm comprennent peu de dynamiques de sorte que l'établissement de leur réponse temporelle en tension au courant I est rapide. Les moyens 20 d'établissement comprennent par exemple un échantillonneur 22 pour échantillonner le courant I acquis par les moyens 14 d'acquisition et des moyens $24_1$, $24_2$, ..., $24_m$ de convolution temporelle numérique du type classique pour déterminer les réponses temporelles en tension V1, V2, ..., Vm des modèles au courant échantillonné comme cela est connu dans l'état de la technique.

Les réponses en tension établies V1, V2, ..., Vm des modèles H1, H2, ..., Hm et la réponse en tension acquise U des moyens 10 de stockage, échantillonnée par exemple par un échantillonneur 26 d'une manière identique à l'échantillonnage du courant acquis I, sont délivrées à des moyens 28 de comparaison. Ces moyens 28 de comparaison sont adaptés pour comparer la réponse en tension acquise U des moyens 10 de stockage aux réponses en tension établies V1, V2, ..., Vm de l'ensemble de modèles prédéterminés H1, H2, ..., Hm et identifier le modèle dont la réponse en tension établie est la plus proche de la réponse en tension acquise des moyens de stockage d'énergie électrique. Le modèle dont la réponse en tension établie est la plus proche de la réponse en tension acquise des moyens 10 de stockage est le plus représentatif de la transmittance de ceux-ci et donc de l'état de charge courant des moyens 10 de stockage.

Les moyens 28 de comparaison sont raccordés à des moyens 30 de détermination de l'état de charge des moyens 10 de stockage. Les moyens 30 de détermination sont adaptés pour déterminer l'état de charge des moyens 10 de stockage d'énergie électrique comme étant l'état de charge correspondant au modèle identifié. A cet effet, les moyens 30 comprennent la cartographie ECi = f(Hi) prédéterminée susmentionnée d'états de charge, par exemple sous la forme d'une table de correspondance adaptée pour délivrer l'état de charge de la cartographie qui correspond à la référence du modèle identifié.

Les moyens 28 de comparaison sont adaptés pour déterminer laquelle des réponses en tension établies V1, V2, ..., Vm des modèles est la plus proche, au sens d'un critère prédéterminé, de la réponse en tension acquise U des moyens 10 de stockage.

Comme cela est illustré sur la figure, un premier mode de réalisation des moyens 28 de comparaison comprend des moyens 32 de formation des erreurs quadratiques C1, C2, ..., Cm entre la réponse en tension acquise U des moyens 10 de stockage et les réponses en tension établies V1, V2, ..., Vm de l'ensemble de modèles.

Ces moyens 32 de formation des erreurs quadratiques comprennent par exemple m soustracteurs S1, S2, ..., Sm qui reçoivent en entrée les réponses V1, V2, ..., Vm respectivement ainsi que la réponse en tension U pour former et délivrer m différences d1, d2,..., dm respectivement où $d_i = V_i - U; i=1,...,m$.

Chaque soustracteur S1, S2, ..., Sm est relié à des moyens T1, T2, ..., Tm de calcul de moyenne quadratique. Les moyens T1, T2, ..., Tm de calcul déterminent la moyenne quadratique C1, C2, ..., Cm de la différence de tension d1, d2, ..., dm qu'ils reçoivent en entrée du soustracteur associé, et forment donc l'erreur quadratique entre la réponse en tension établie V1, V2,..., Vm du modèle associé et la réponse en tension acquise U des moyens 10 de stockage.

L'ensemble des erreurs quadratiques C1, C2, ..., Cm est délivré à des moyens 34 d'identification adaptés pour identifier le modèle dont la réponse en tension établie est la plus proche de la réponse en tension acquise des moyens de stockage d'énergie électrique comme étant le modèle associé à l'erreur quadratique C1, C2, ..., Cm minimale et délivrent la référence de ce modèle aux moyens 30 de détermination.

Un autre mode de réalisation des moyens 28 de comparaison se fonde sur un autre critère de comparaison, c'est-à-dire la valeur de l'intercorrelation entre la réponse en tension acquise U des moyens 10 de stockage et la réponse en tension établie V1, V2, ..., Vm d'un modèle H1, H2, ..., Hm.

A cet effet, les moyens 28 de comparaison comprennent dans ce mode de réalisation des moyens d'intercorrelation pour déterminer les intercorrelations entre la réponse en tension acquise U des moyens 10 de stockage et les réponses en tension établies V1, V2, ..., Vm de l'ensemble de modèles prédéterminés. Ces moyens d'intercorrelation délivrent ces intercorrelations à des moyens d'identification adaptés pour identifier le modèle dont la réponse en tension établie est la plus proche de la réponse en tension acquise des moyens de stockage d'énergie électrique comme étant le modèle associé à la valeur d'intercorrelation maximale, et délivrer la référence de ce modèle aux moyens de détermination.

Un autre mode de réalisation des moyens 28 de comparaison se fonde quant à lui sur un troisième critère de comparaison qui est l'erreur quadratique entre la transformée de Fourier de la réponse en tension acquise U des moyens 10 de stockage et la transformée de Fourier de la réponse en tension établie V1, V2, ..., Vm d'un modèle.

A cet effet, les moyens 28 de comparaison comprennent des moyens de détermination des transformées de Fourier des réponses en tension U, V1, V2, ..., Vm des moyens 10 de stockage d'énergie électrique et de l'ensemble prédéterminé de modèles. Les transformées de Fourier sont alors délivrées à des moyens de formation d'erreur quadratique qui déterminent les erreurs quadratiques entre la transformée de Fourier de la réponse en tension acquise des moyens de stockage d'énergie électrique et les transformées de Fourier des réponses en tension établies de l'ensemble de modèles prédéterminés. Ces erreurs quadratiques sont ensuite délivrées à des moyens d'identification adaptés pour identifier le modèle dont la réponse en tension établie est la plus proche de la réponse en tension acquise des moyens de stockage d'énergie électrique comme étant le modèle H1, H2, ..., Hm associé à l'erreur quadratique de transformées de Fourier minimale et pour délivrer la référence de ce modèle aux moyens 30 de détermination.

La qualité de la comparaison mise en oeuvre par les moyens 28 de comparaison dépend de la représentativité des réponses en tension de l'ensemble des modèles vis-à-vis de la réponse en tension des moyens 10 de stockage. On comprendra par exemple que, si les modèles constituent une représentation mathématique sensiblement exacte de la transmittance réelle des moyens 10 de stockage pour une bande prédéterminée de fréquences, une excitation de ces modèles sensiblement majoritairement dans une bande de fréquences différente a pour effet l'établissement de réponses en tension établies des modèles H1, H2, ..., Hm non représentatives de la réponse acquise des moyens 10 de stockage. La comparaison de celles-ci avec la réponse en tension des moyens 10 de stockage ne permet alors pas de déterminer de façon satisfaisante l'état de charge EC de ceux-ci.

Afin d'exciter de manière satisfaisante les modèles H1, H2, ..., Hm, les moyens 16 de sollicitation sont adaptés pour solliciter en courant les moyens 10 de stockage selon une séquence binaire pseudo-aléatoire excitant les modèles dans la bande de fréquences dans laquelle ils sont chacun représentatifs des moyens 10 de stockage pour l'état de charge associé. Par exemple, la séquence binaire pseudo-aléatoire est celle utilisée pour l'identification des modèles lors de l'étude antérieure.

Il peut être noter que d'autres formes de courant peuvent être utilisée comme un créneau de courrant unique par exemple. L'utilisation d'un tel créneau de courant permet d'accélérer l'établissement des réponses des modèles mais réduit la robustesse de la comparaison et de l'identification du modèle considéré comme le plus représentatif des moyens 10 de stockage.

Un autre mode de réalisation du système selon l'invention ne comprend pas les moyens 16 de sollicitation pour imposer un courant total échangé du type souhaité.

Dans ce mode de réalisation, les moyens 14 d'acquisition sont adaptés pour déclencher la détermination de l'état de charge EC lorsque le courant échangé par les moyens 10 de stockage et l'ensemble 12 d'organes fonctionnels présente une ou plusieurs caractéristiques fréquentielles satisfaisantes pour l'excitation des modèles. Par exemple les moyens 14 de détection et d'acquisition et les moyens 18 d'acquisition de la réponse en tension des moyens 10 de stockage comprennent des mémoires tampon pour mémoriser le courant et la réponse en tension correspondante respectivement. Les moyens 14 de détection et d'acquisition du courant sont adaptés pour analyser le courant mémorisé et déterminer si son support fréquentiel est sensiblement contenu dans la bande prédéterminée de fréquences excitatrices des modèles. Si cela est le cas, le courant I acquis et la réponse en tension acquise U correspondante sont alors délivrés aux moyens 20 d'établissement des réponses en tension de l'ensemble de modèles prédéterminés et les moyens 28 de comparaison et de détermination de l'état de charge pour la détermination de l'état de charge des moyens 10 de stockage comme cela a été décrit précédemment.

Comme il est possible de le constater, le système selon l'invention est applicable à tout type de moyens de stockage d'énergie électrique pour véhicule du type automobile, motocycle ou autre.

**Revendications**

1. Système de détermination de l'état de charge de moyens (10) de stockage d'énergie électrique de véhicule, **caractérisé en ce qu'**il comprend :

   - des moyens (14) de détection et d'acquisition d'un courant d'un type prédéterminé, échangé entre les moyens (10) de stockage d'énergie électrique et leur environnement ;
- des moyens (18) d'acquisition d'une réponse en tension des moyens de stockage d'énergie électrique à ce courant échangé ;
- des moyens (20) d'établissement de réponses en tension à ce courant échangé d'un ensemble de modèles prédéterminés des moyens (10) de stockage d'énergie électrique correspondant à différents états de charge de ceux-ci;
- des moyens (28) de comparaison adaptés pour comparer la réponse en tension acquise des moyens (10) de stockage d'énergie électrique aux réponses en tension établies de l'ensemble de modèles prédéterminés, et pour identifier le modèle dont la réponse en tension établie est la plus proche de la réponse en tension acquise des moyens de stockage d'énergie électrique ; et
- des moyens (30) de détermination de l'état de charge des moyens (10) de stockage d'énergie électrique comme étant l'état de charge correspondant au modèle identifié.

**2.** Système selon la revendication 1, **caractérisé en ce qu'**il comprend en outre, raccordés au moyens (10) de stockage d'énergie électrique, des moyens (16) de sollicitation en courant de ceux-ci selon une consigne prédéterminée de courant.

**3.** Système selon la revendication 2, **caractérisé en ce que** la consigne prédéterminée de courant est une séquence binaire pseudo-aléatoire prédéterminée excitatrice dans une bande prédéterminée de fréquences pour laquelle les modèles de l'ensemble de modèles sont représentatifs de la réponse fréquentielle en tension des moyens (10) de stockage d'énergie électrique.

**4.** Système selon l'une quelconque des revendications précédentes, **caractérisé en ce que** les moyens (28) de comparaison comprennent :

- des moyens (32) de formation des erreurs quadratiques entre la réponse en tension acquise des moyens (10) de stockage d'énergie électrique et les réponses en tension établies de l'ensemble de modèles prédéterminés ; et
- des moyens (34) d'identification du modèle dont la réponse en tension établie est la plus proche de la réponse en tension acquise des moyens de stockage d'énergie électrique comme étant le modèle associé à l'erreur quadratique minimale.

**5.** Système selon l'une quelconque des revendications 1 à 3, **caractérisé en ce que** les moyens de comparaison comprennent :

- des moyens de détermination des intercorrelations entre la réponse en tension acquise des moyens de stockage d'énergie électrique et les réponses en tension établies de l'ensemble de modèles prédéterminés; et
- des moyens d'identification du modèle dont la réponse en tension établie est la plus proche de la réponse en tension acquise des moyens de stockage d'énergie électrique comme étant le modèle associé à l'intercorrelation maximale.

**6.** Système selon la revendication 1 à 3, **caractérisé en ce que** les moyens de comparaison comprennent :

- des moyens de détermination des transformée de Fourier des réponses en tension acquise des moyens de stockage d'énergie électrique et des réponses en tension établies de l'ensemble de modèles prédéterminés;
- des moyens de formation des erreurs quadratiques entre la transformée de Fourier de la réponse en tension acquise des moyens de stockage d'énergie électrique et les transformées de Fourier des réponses en tension établies de l'ensemble de modèles prédéterminés ; et
- des moyens d'identification du modèle dont la réponse en tension établie est la plus proche de la réponse en tension acquise des moyens de stockage d'énergie électrique comme étant le modèle associé à l'erreur quadratique de transformées de Fourier minimale.

**7.** Système selon l'une quelconque des revendications précédentes, **caractérisé en ce que** l'ensemble de modèles prédéterminés est constitué d'un ensemble de modèles prédéterminés non entiers de la transmittance des moyens (10) de stockage d'énergie électrique, chacun représentatif d'une valeur prédéterminée d'état de charge des moyens (10) de stockage d'énergie électrique.

**8.** Système selon la revendication 7, **caractérisé en ce que** l'ensemble de modèles prédéterminés non-entiers de la transmittance des moyens (10) de stockage d'énergie électrique est constitué de modèles selon la relation :

$$H(p) = K \left( \frac{1 + \dfrac{p}{\omega_b}}{1 + \dfrac{p}{\omega_r}} \right)^n$$

où H est un modèle de transmittance en fonction de la variable de Laplace p, n est un ordre non entier

prédéterminé, et K, $\omega_b$ et $\omega_r$ sont des paramètres prédéterminés, n, K, $\omega_b$ et $\omega_r$ étant représentatifs ensembles de l'état de charge des moyens de stockage d'énergie électrique.

# EP 1 653 241 A1

| | **Office européen** **des brevets** | **RAPPORT DE RECHERCHE EUROPEENNE** | **Numéro de la demande** EP 05 29 2198 |
|---|---|---|---|

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 6 118 275 A (YOON ET AL) 12 septembre 2000 (2000-09-12) * le document en entier * ----- | 1,3-5 | G01R31/36 |
| A | EP 0 505 333 A (ENTE PER LE NUOVE TECNOLOGIE, L'ENERGIA E L'AMBIENTE) 23 septembre 1992 (1992-09-23) * le document en entier * ----- | 1,3-5 | |
| A | US 2002/169581 A1 (SARFERT CHRISTEL) 14 novembre 2002 (2002-11-14) * revendication 1 * ----- | 1 | |

**DOMAINES TECHNIQUES RECHERCHES (IPC)**

G01R

Le présent rapport a été établi pour toutes les revendications

| Lieu de la recherche | Date d'achèvement de la recherche | Examinateur |
|---|---|---|
| La Haye | 11 janvier 2006 | Koll, H |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**EP 1 653 241 A1**

ANNEXE AU RAPPORT DE RECHERCHE EUROPEENNE
RELATIF A LA DEMANDE DE BREVET EUROPEEN NO.

EP 05 29 2198

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

11-01-2006

| Document brevet cité au rapport de recherche | | Date de publication | Membre(s) de la famille de brevet(s) | | Date de publication |
|---|---|---|---|---|---|
| US 6118275 | A | 12-09-2000 | JP<br>JP<br>KR | 3162030 B2<br>2000019234 A<br>2000003044 A | 25-04-2001<br>21-01-2000<br>15-01-2000 |
| EP 0505333 | A | 23-09-1992 | AT<br>DE<br>DE<br>IT | 175029 T<br>69227938 D1<br>69227938 T2<br>1244942 B | 15-01-1999<br>04-02-1999<br>22-07-1999<br>13-09-1994 |
| US 2002169581 | A1 | 14-11-2002 | DE<br>EP | 10106505 A1<br>1231475 A2 | 29-08-2002<br>14-08-2002 |

EPO FORM P0460

Pour tout renseignement concernant cette annexe : voir Journal Officiel de l'Office européen des brevets, No.12/82